# EUROPEAN PATENT APPLICATION

(11) **EP 3 693 792 A1**
(43) Date of publication of application: **12.08.2020**
(21) Application number: 19156029.1
(22) Date of filing: 07.02.2019
(51) Int. Cl.: G03F 1/32, G03F 1/24

(54) **A PATTERNING DEVICE AND METHOD OF USE THEREOF**

(71) Applicant: ASML Netherlands B.V., 5500 AH Veldhoven (NL)
(72) Inventor: VAN LARE, Marie-Claire, 5500 AH Veldhoven (NL); TIMMERMANS, Frank, Jan, 5500 AH Veldhoven (NL); WITTEBROOD, Friso, 5500 AH Veldhoven (NL); MCNAMARA, John, Martin, 5500 AH Veldhoven (NL)
(74) Representative: Slenders, Petrus Johannes Waltherus

(57) **Abstract**

An attenuated phase shift patterning device comprising a first component for reflecting radiation, and a second component for reflecting radiation with a different phase with respect to the radiation reflected from the first component, the second component covering at least a portion of the surface of the first component such that a pattern comprising at least one uncovered portion of the first component is formed for generating a patterned radiation beam in a lithographic apparatus in use, wherein the second component comprises a material having a refractive index with a real part (n) being less than 0.95 and an imaginary part (k) being less than 0.04.

## Description

### FIELD

The present invention relates to a patterning device and method of use of the patterning device. More particularly, it relates to an attenuated phase shift patterning device.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In a lithographic apparatus, increasing the numerical aperture (NA) of the objective lens results in improved critical dimension uniformity and higher effective throughput. As the NA of the lithographic apparatus increases, the depth of focus reduces. Techniques such as source-mask optimization (SMO) can be used to trade-off Normalised Image Log Slope (NILS) with depth of focus. However, when NILS-through-focus needs to be high, this becomes increasingly challenging. Consequentially, it is challenging to provide sufficient focal range when the optical contrast is within specification. Therefore, it may be desired to enhance NILS-through-focus.

### SUMMARY

According to a first aspect of the invention, there is provided an attenuated phase shift patterning device comprising a first component for reflecting radiation, and a second component for reflecting radiation with a different phase with respect to the radiation reflected from the first component, the second component covering at least a portion of the surface of the first component such that a pattern comprising at least one uncovered portion of the first component is formed for generating a patterned radiation beam in a lithographic apparatus in use, wherein the second component comprises a material having a refractive index with a real part (n) being less than 0.95 and an imaginary part (k) being less than 0.04.

This may provide an advantage of a more accurate pattern on the substrate due to a reduced patterning device 3D effect. The attenuated patterning device may provide an advantage of a relatively high NILS and a relatively low pattern shift. This may have an advantage of providing a relatively strongly enhanced NILS through focus. This may ultimately improve yield of a lithographic apparatus.

The second component may comprise at least one of Ru, Rh, Tc, Mo and Re.

The second component may comprise an alloy comprising at least one of Ru, Rh, Tc, Mo and Re.

The second component may have a thickness in the range 30 to 45nm. The thickness of the second component may be greater than or equal to 30nm and the thickness of the second component may be less than or equal to 45nm.

The second component may have a thickness in the range 33 to 41nm. The second component may have a thickness of greater than or equal to 33nm and the second component may have a thickness less than or equal to 41nm.

The second component may have a thickness of 35 or 41nm.

The second component may cover the portion of the first component which extends a distance of at least 10nm from the at least one uncovered portion of the first component. The second component may have a width of at least 10nm.

The second component may be in direct contact with the first component. The second component may be not in direct contact with the first component.

The attenuated phase shift patterning device may further comprise a third component for absorbing radiation, the third component may comprise a material having a refractive index with a larger imaginary part (k) than the material of the second component, the third component may cover at least a portion of the first component.

This may provide an advantage of suppressing background intensity in an aerial image. This may have an advantage of providing a relatively strongly enhanced NILS through focus for isolated patterns.

The material of the third component may have a refractive index with an imaginary part (k) in the range 0.031 to 0.08.

The third component may cover the portion of the first component which is greater than or equal to a distance in the range 20 to 240nm from the at least one uncovered portion of the first component.

The third component may not cover the second component. The third component and the second component may be in the same layer.

The third component may be in direct contact with the first component. The third component may be not in direct contact with the first component.

The third component may cover at least a portion of the second component. The third component and the second component may be in different layers. The third component may be located on the second component.

The third component may be in direct contact with the second component. The third component may be not in direct contact with the second component.

The third component may comprise at least one of Ta, Ag, Pt, Pd, Au, Ir, Os, Re, In, Co, Cd, Pb, Fe, Hg, TI, Cu, Zn, I, Te, Ga, Cr, W, Hf, TaBN, and an alloy comprising one or more of Ta, Ag, Pt, Pd, Au, Ir, Os, Re, In, Co, Cd, Pb, Fe, Hg, TI, Cu, Zn, I, Te, Ga, Cr, W, and Hf.

The second component may cover the entire first component except the at least one uncovered portion of the first component.

The first component may be a multilayer.

The pattern may comprise a plurality of uncovered portions of the first component.

According to a second aspect of the invention, there is provided a method of using an attenuated phase shift patterning device, comprising reflecting radiation from a first component of the attenuated phase shift patterning device, and reflecting radiation from a second component of the attenuated phase shift patterning device such that the radiation reflected from the second component has a different phase with respect to the radiation reflected from the first component, the second component covering at least a portion of the surface of the first component such that a pattern comprising at least one uncovered portion of the first component is formed for generating a patterned radiation beam, wherein the second component comprises a material having a refractive index with a real part (n) being less than 0.95 and an imaginary part (k) being less than 0.04.

The method may further comprise absorbing radiation using a third component having a refractive index with a larger imaginary part (k) than the second component, the third component covering at least a portion of the first component.

It will be appreciated that one or more aspects or features described above or referred to in the following description may be combined with one or more other aspects or features.

### BRIEF DESCRIPTION OF THE DRAWINGS

Embodiments of the invention will now be described, by way of example only, with reference to the accompanying schematic drawings, in which:
- Figure 1 depicts a schematic diagram of a lithographic system comprising a lithographic apparatus and a radiation source in accordance with an embodiment of the invention;
- Figure 2a depicts a schematic diagram of a cross sectional side view of an attenuated phase shift patterning device in accordance with an embodiment of the invention;
- Figure 2b depicts a schematic diagram of a top view of an attenuated phase shift patterning device in accordance with the embodiment of Figure 2a;
- Figure 3 depicts a series of graphs showing NILS optimization of an attenuated phase shift patterning device in accordance with an embodiment of the invention;
- Figure 4 depicts a series of graphs showing pattern shift optimization of an attenuated phase shift patterning device in accordance with an embodiment of the invention;
- Figure 5 depicts graphs showing NILS over a range of Half Pitch (HP) of an attenuated phase shift patterning device in accordance with an embodiment of the invention;
- Figure 6 depicts a graph showing depth of focus (DOF) over a range of Half Pitch (HP) of an attenuated phase shift patterning device in accordance with an embodiment of the invention;
- Figure 7a depicts a patterning device layout for isolated patterns;
- Figure 7b depicts an isolated patterns aerial image having a background;
- Figure 7c depicts an isolated patterns aerial image without a background;
- Figure 8a depicts a schematic diagram of a cross sectional side view of an attenuated phase shift patterning device in accordance with another embodiment of the invention;
- Figure 8b depicts a schematic diagram of a top view of an attenuated phase shift patterning device in accordance with the embodiment of Figure 8a;
- Figure 9a depicts a schematic diagram of a cross sectional side view of an attenuated phase shift patterning device in accordance with another embodiment of the invention;
- Figure 9b depicts a schematic diagram of a top view of an attenuated phase shift patterning device in accordance with the embodiment of Figure 9a.

### DETAILED DESCRIPTION

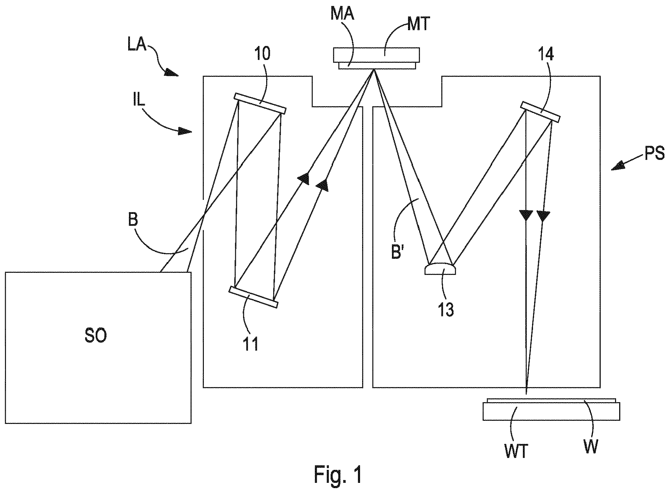

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

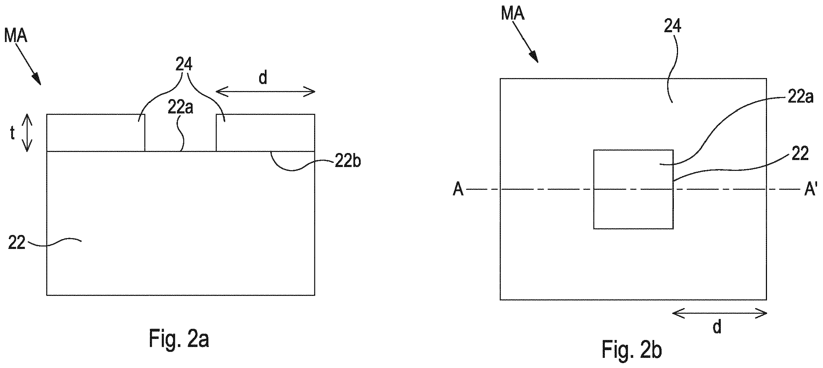

Figure 2a shows a close up side view of part of the patterning device MA, which in this embodiment is an attenuated phase shift patterning device. More particularly, Figure 2a shows a cross sectional side view of the attenuated phase shift patterning device MA taken through line A-A' of Figure 2b. A part of the attenuated phase shift patterning device MA is shown in Figure 2b in a top view. It will be appreciated that Figures 2a and 2b show only part of the attenuated phase shift patterning device MA for clarity as will become apparent.

Phase shift patterning devices are photomasks that take advantage of the interference generated by phase differences to improve image resolution in photolithography. A phase shift patterning device relies on the fact that radiation passing through a transparent media (i.e. in this case being reflected from that media) will undergo a phase change as a function of its optical thickness.

The attenuated phase shift patterning device MA comprises a first component 22 for reflecting radiation and a second component 24 for reflecting radiation with a different phase with respect to the radiation reflected from the first component. The first component 22 comprises a standard multilayer mirror, e.g. alternating layers of molybdenum and silicon. The layers of the multilayer are not shown in Figure 2a for simplicity. It will be appreciated that in other embodiments, the first component may have different numbers of layers and/or may comprise different materials.

The second component 24 is in a different layer from the first component 22, i.e. the second component 24 is located on the first component 22.

The second component 24 reflects a relatively small amount of radiation when compared with the first component 22. The radiation reflected from the second component 24 is not strong enough to create a pattern on the substrate W, but it can interfere with the radiation coming from the first component 22, with the goal of improving the contrast on the substrate W. The contrast may be considered to be the steepness, or sharpness, of the features formed in the image on the substrate W.

As can be seen in Figure 2a and Figure 2b, the second component 24 covers a portion (hereinafter referred to as a covered portion 22b) of the first component 22 except for an uncovered portion 22a of the surface of the first component 22 which forms a pattern. Radiation reflected from the uncovered portion 22a generates the patterned radiation beam B' which forms a pattern in a target portion of the substrate W in the lithographic apparatus LA when in use. The second component 24 may be considered to surround the uncovered portion 22a of the first component 22, albeit that the second component 24 is in a different layer from the first component 22 and so it is actually the covered portions 22b that surround the uncovered portions 22a of the first component 22. The second component 24 may be considered to form a ring around the uncovered portion 22a of the first component 22. Although the area of the uncovered portion 22a of the first component 22 is shown as substantially a square or rectangle from above, in other embodiments, the uncovered portion may be any suitable shape and the second component may have a size and shape accordingly. The size of the uncovered portion 22a is related to the critical dimension (CD) of the feature to be printed on the substrate W. On the patterning device MA, the size of the uncovered portion 22a is the CD (on the substrate W) multiplied by the magnification factor in the lithographic apparatus LA. This may have a range of +/- 30% (patterning device bias range). The magnification factor may be 4-8.

The second component 24 covers the covered portion 22b of the first component 22 which extends a distance of 10nm from the uncovered portion 22a of the first component 22. It may be considered that the second component 24 extends this distance from the uncovered portion 22a of the first component 22. This distance being taken parallel to the surface of the first component 22, i.e. it may be considered to be taken along an interface between the first component 22 and the second component 24. In other words, the second component 24 has a width d of 10nm which obviously corresponds to the extent in that direction of the covered portion 22b of the first component 22. The width d is depicted as a double arrow in Figures 2a and 2b. It will be appreciated that in other embodiments, the second component 24 may extend a different distance from the uncovered portion 22a, e.g. it may extend more than 10nm. Generally, the size of the pattern of the patterning device MA may be the same as for a conventional mask. The pattern of the patterning device MA equals the pattern that is desired to be printed on the substrate multiplied by a mask magnification factor. The mask magnification factor may be 4-8. In some embodiments, the second component 24 covers the entire first component 22 except from the uncovered portion 22a of the first component 22.

Although only a single uncovered portion 22a is shown in Figure 2a and 2b, (because these Figures only show part of the attenuated phase shift patterning device MA), it will be appreciated that the pattern may be formed of a plurality of uncovered portions 22a. The pattern may be a dense pattern or may be an isolated pattern. A pattern may be considered to be dense when the critical dimension (CD), c.f. the size of the uncovered portion, is at least half of the pitch of the pattern. A pattern may be considered to be isolated where the pitch is increased and therefore the CD (c.f. the size of the uncovered portion) is less than half of the pitch of the pattern. Each of the plurality of uncovered portions 22a may be surrounded by covered portions 22b of the first component 22. The portions of the second component 24 adjacent to the uncovered portions 22a may extend a distance of 10nm from the uncovered portions 22a in the direction parallel to the surface of the first component 22. This being the same as the distance the covered portions 22b extend in that direction. In some embodiments, the second component 24 may extend more than 10nm in the direction parallel to the surface of the first component 22. In some embodiments, the second component 24 covers the entire first component 22 except from the uncovered portions 22a of the first component 22.

The terms cover/covered/covering as used within this description is intended to mean that the covering component is in a position such that radiation is at least partially blocked from being incident on the portion of the covered component underneath the covering component. That is, covering may be taken to encompass covering where the covering component is in direct contact with the covered component or not, i.e. another component may or may not be located between the component that is covering and the component being covered.

In this embodiment, the second component 24 comprises the material Ruthenium (Ru) with a thickness t (shown as a double arrow in Figures 2a and 2b) of 35nm. The material Ru of the second component 24 may be considered to have replaced an absorbing material, e.g. a TaBN absorber, in a standard patterning device to form the attenuated phase shift patterning device MA. As will be appreciated, in other embodiments, different materials may be used in place of Ru, as detailed later.

The Ru acts as a phase shift material and it has been found to be a particularly good material to use in the attenuated phase shift patterning device MA. Furthermore, the thickness of 35nm has been found to provide an optimal phase shift. As will be appreciated, in other embodiments, different thicknesses may also be used, as detailed later.

The attenuated phase shift patterning device MA may be used in the lithographic apparatus LA by reflecting radiation from the first component 22 of the attenuated phase shift patterning device MA, and reflecting radiation from the second component 24 of the attenuated phase shift patterning device MA. More particularly, reflecting radiation from the pattern comprising the uncovered portion 22a of the first component 22 and generating the patterned radiation beam B'. The effect of this is that the radiation reflected from the second component 24 has a different phase with respect to the radiation reflected from the first component 22 and provides a pattern on the substrate with increased contrast.

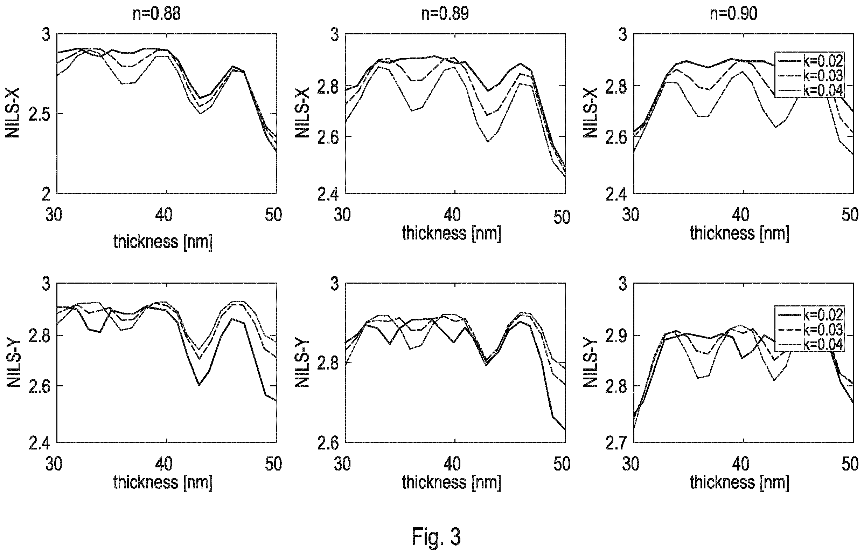

Figure 3 shows graphs displaying selected results of the Normalised Image Log Slope (NILS) optimisation of the attenuated phase shift patterning device MA. As mentioned previously, as the numerical aperture (NA) of the lithographic apparatus LA increases, the depth of focus reduces. Techniques such as source-mask optimization (SMO) can be used to trade-off NILS with depth of focus. However, it is challenging to maintain a high NILS-through-focus, i.e. a high contrast at different points around the target focal point. The optimization of the attenuated phase shift patterning device MA was done by simulating a monopole source and co-optimizing NILS (max NILS) and pattern shift (min pattern shift). The pattern shift may be considered to a measure of how much the pattern moves for a particular point.

The NILS optimization included simulating a small scan over different thicknesses of the second component 24 with the material having different n and k values. These values could be varied by mixing different elements (e.g. Ru and a material with different n and k). The bottom row of the graphs show the values of NILS for a scan in the Y direction (i.e. the scanning direction of the lithographic apparatus LA) for different thicknesses of the second component 24. The top row of graphs show the values of NILS for a scan in the X direction (i.e. the direction perpendicular to the scanning direction of the lithographic apparatus LA) for different thicknesses of the second component 24. The graphs from left to right have increasing n (i.e. n=0.88, n=0.89 and n=0.90) and the different values of k are shown in different dashed lines (i.e. k=0.02, k=0.03, k=0.04; see key on the right hand side graphs).

As may be seen from the graphs of Figure 3, the optimum NILS is obtained with n=0.88, k=0.02 and a thickness less than or equal to 45 nm. That is, at these values, the results show a relatively large NILS value. Furthermore, the gradient is not varying very much, which means that small changes in the thickness of the material will not result in significant changes to the contrast of the pattern in the substrate W. The optimum n and k values found in the simulation equal the n and k values of Ru and thus Ru is a particularly good choice to use as the phase shift material.

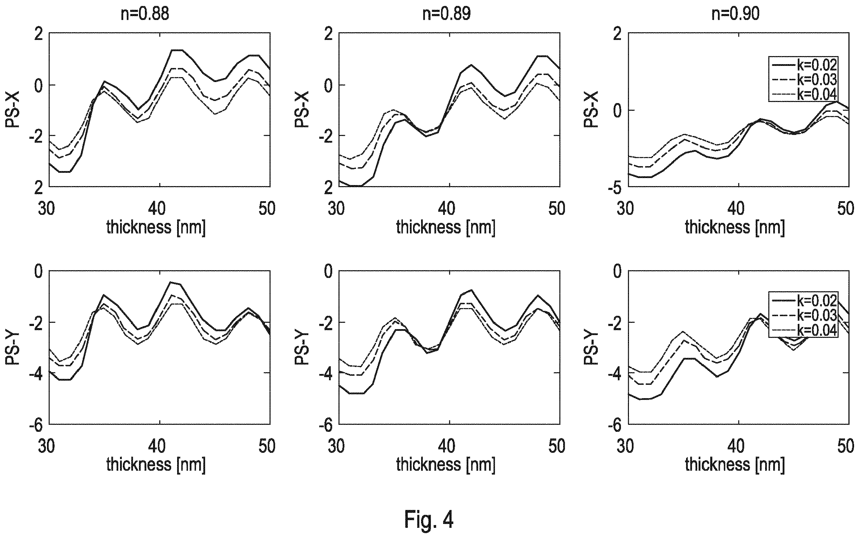

Figure 4 shows graphs displaying selected results of the pattern shift (PS) optimisation of the attenuated phase shift patterning device MA. The bottom row of the graphs show the values of pattern shift for a scan in the Y direction (i.e. the scanning direction of the lithographic apparatus LA) for different thicknesses of the second component 24. The top row of graphs show the values of pattern shift for a scan in the X direction (i.e. the direction perpendicular to the scanning direction of the lithographic apparatus LA) for different thicknesses of the second component 24. Again the graphs from left to right have increasing n (i.e. n=0.88, n=0.89 and n=0.90) and the different values of k are shown in different dashed lines (i.e. k=0.02, k=0.03, k=0.04; see key on the right hand side graphs).

As may be seen from the graphs of Figure 4, the smallest (i.e. optimum) pattern shift is obtained with n=0.88, k=0.02 and a thickness of 35nm or 41nm. That is, at these values, the pattern shift is relatively low.

Taking the NILS optimization and the pattern shift optimization into account, then the best overall result is obtained with a second component 24 having a material with n=0.88, k=0.02 and a thickness of 35nm or 41nm. This provides an optimum balance between a relatively high NILS, a relatively low variance of the gradient of thickness against NILS, and a relatively low pattern shift (PS). Therefore, the attenuated phase shift patterning device MA having a second component comprising the material Ru and having a thickness of 35nm as shown in Figures 2a and 2b may be considered to be particularly advantageous.

Using Ru has several advantages when compared to using Ta in the patterning device which ultimately leads to an improved yield of the lithographic apparatus LA. These advantages include obtaining a larger phase shift, which means a larger NILS (i.e. an enhanced contrast of the features on the substrate W).

Generally, the patterning device having a finite thickness (i.e. a 3D effect) leads to artefacts, i.e. shadowing, being produced in the lithographic apparatus LA. Since Ru has a refractive index with a relatively low real part (n), then the required phase shift can be obtain in a thinner layer. Thus, the patterning device may be made thinner which leads to a reduced patterning device 3D effect. This provides a more accurate pattern on the substrate W.

In addition, there are relatively low absorption losses in the attenuated phase shift patterning device MA. This is because Ru has a refractive index with a relatively low real part (n) and a relatively low imaginary part (k). Thus, it doesn't absorb as much radiation as other materials that may be used, e.g. Ta, and obtaining the required phase shift in a relatively thin layer means that the radiation needs to pass through less material and is absorbed less. The low absorption losses in the attenuated phase shift patterning device MA means that there is more radiation to interfere, which leads to a larger NILS.

The relatively low k of the patterning device MA is required to properly balance the amplitudes of the diffraction orders. Unless there is a low k, there may not be enough radiation left in the reflected patterned EUV radiation beam B' to sufficiently supress the intensity of the zeroth diffraction order. However, it has been realised that it is important to understand the optimum amount of k. This is because there is a need to balance the diffraction orders.

It will be appreciated that the second component does not need to have the optimum n and k values in order to obtain at least some of these benefits to at least some extent. In other embodiments, the material of the second component may have a refractive index with a real part (n) being less than 0.95 and an imaginary part (k) being less than 0.04. Materials having a refractive index falling within these limits may also provide a relatively high NILS and a relatively low pattern shift. These materials may be, for example, Rhodium (Rh), Technetium (Tc), Molybdenum (Mo) and Rhenium (Re). Thus, the second component may comprise one or more of Ru, Rh, Tc, Mo and Re. In other embodiments, the second component may comprise an alloy comprising one or more of Ru, Rh, Tc, Mo and Re.

It will also be appreciated that advantages may also be obtained when the thickness of the Ru is not 35 or 41nm, as may be seen in Figures 3 and 4. In other embodiments, the thickness of the second component comprising the material Ru may be in the range 30 to 45nm. That is, the thickness of the second component may be greater than or equal to 30nm and the thickness of the second component may be less than or equal to 45nm. In other embodiments, the second component may have a thickness in a range 33nm to 41nm. That is, the second component may have a thickness of greater than or equal to 33nm and the second component may have a thickness less than or equal to 41nm.

It will be appreciated that in embodiments where the second component has a material of at least one of Rh, Tc, Mo and Re, or an alloy of at least one of the elements Ru, Rh, Tc, Mo and Re, the thickness of the second component may vary accordingly, e.g. in order to obtain the best results.

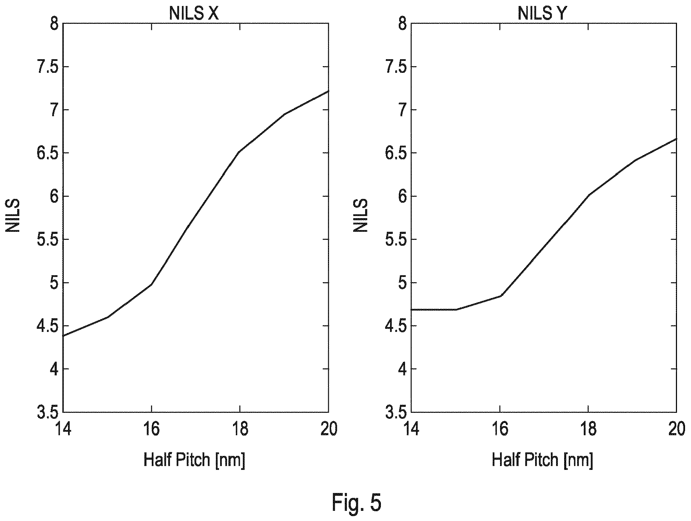

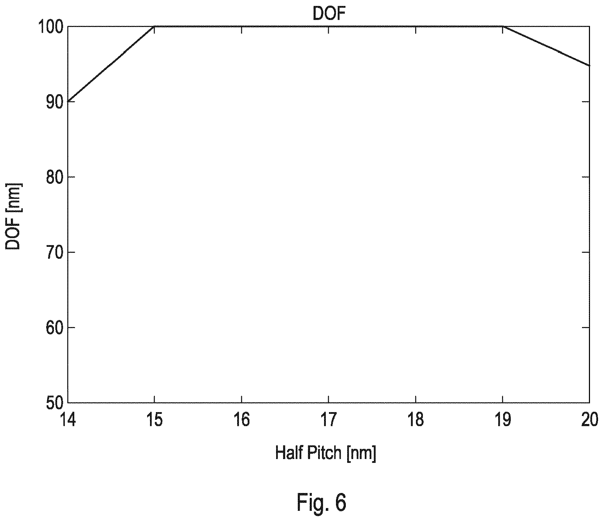

Figures 5 and 6 show the performance of the attenuated phase shift patterning device MA of Figure 2. That is, with the second component 24 of the attenuated phase shift patterning device MA comprising the material Ru. The results shown in Figures 5 and 6 are obtained by combining the attenuated phase shift patterning device MA with an optimized pupil (i.e. one single pupil for the whole pitch range).

More particularly, Figure 5 shows a graph on the left hand side with the NILS values for a cross section over contact hole along the X direction, and a graph on the right hand side shows the NILS values for a cross section along the Y direction, for a range 14-20nm of half pitch (HP). Half pitch (HP) refers to half the distance between two features formed on the substrate W. The graphs show that both the NILS-X and the NILS-Y values are above 4 for the whole range of HP. Thus, there is a relatively very large NILS through focus, throughout the whole 14-20nm half pitch (HP) range, when compared with a standard patterning device.

Figure 6 shows a graph of depth of focus (DOF) over the 14-20nm half pitch (HP) range. The DOF is between 90 to 100 nm (inclusive) over the full range of HP. This is a substantially larger DOF than a standard Ta patterning device, which may have a DOF of e.g. 20nm.

Therefore, the attenuated phase shift patterning device MA provides a relatively high NILS and DOF over a full range of HP. This is surprising as typically materials would have varying NILS and DOF for different values of HP over this range. This would mean that the patterning device would need to be changed each time a different HP was being used. Thus, the attenuated phase shift patterning device MA may reduce the requirement to change components in the lithographic apparatus LA. This may result in an increase in efficiency in using the lithographic apparatus LA for different HPs.

As mentioned above, the pattern may have a plurality of uncovered portions 22a of the first component 22 and the pattern may be dense or isolated. The attenuated phase shift patterning device MA shown in Figure 2 works very well for dense patterns, but for isolated patterns, it leads to the addition of a background in the aerial image.

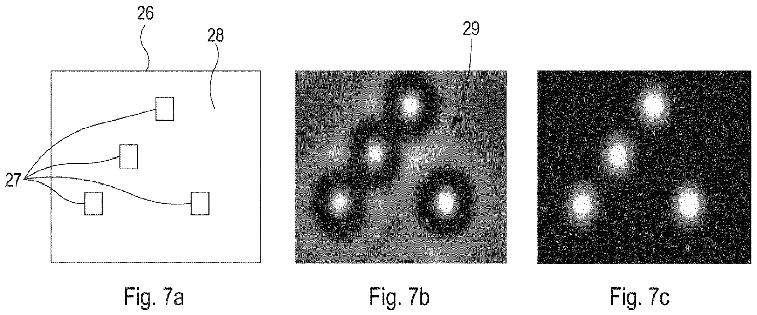

Figure 7a shows an example of an isolated pattern that may be located on a patterning device 26. The features (e.g. uncovered portions) 27 reflect the radiation whilst the portion 28 of the patterning device does not reflect radiation strong enough to create a pattern on the substrate W. Figure 7b shows the aerial image of the attenuated phase shift patterning device MA of Figure 2 (i.e. with a second component comprising the material Ru). Figure 7c shows the desired aerial image, i.e. having no background.

As may be seen from Figure 7b, there is a background 29 in the aerial image which is not shown in the desired aerial image of Figure 7c. This background 29 is due to the reduced absorption coefficient of the phase-shifting material (in this case Ru) compared to Ta. The background 29 will lead to undesired resist conversion in the isolated areas of the pattern and therefore is desired to be suppressed.

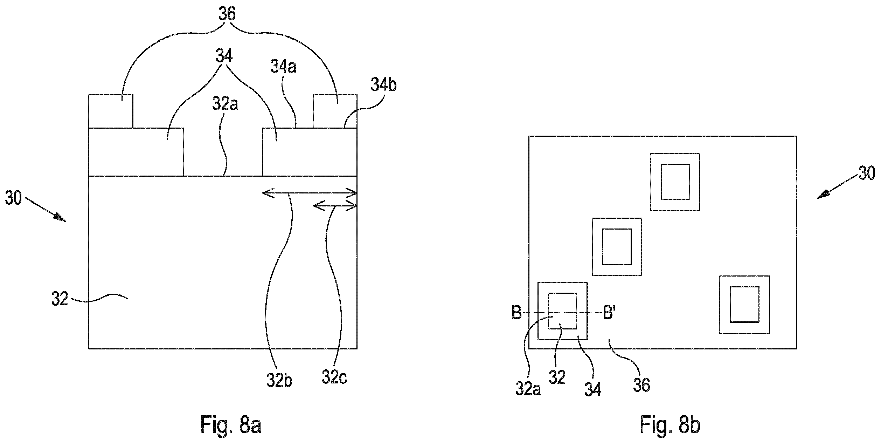

Figure 8a shows a side view of an embodiment of part of an attenuated phase shift patterning device 30. More particularly, Figure 8a shows a cross sectional side view of the attenuated phase shift patterning device 30 taken through line B-B' of Figure 8b. The attenuated phase shift patterning device 30 is shown more fully in Figure 8b in a top view.

The attenuated phase shift patterning device 30 is similar to the attenuated phase shift patterning device MA, except, in addition to a first component 32 and a second component 34, there is a third component 36 covering a portion of the first component 32. More particularly, in this embodiment, the third component 36 covers a portion of the second component 34 such that the second component 34 has an uncovered portion 34a and a covered portion 34b. The second component 34 may be considered to form a ring around the uncovered portion 32a of the first component 32.

In this embodiment, the third component 36 is not located directly on the first component 32, i.e. the second component 34 is located between the first component 32 and the third component 36. That is, the second component 34 is in a different layer from the third component 36. However, the third component 36 may still be considered to be covering a portion of the first component 32, even with the second component 34 located therebetween. More generally, the third component 36 covers at least a portion of the second component 34. The third component 36 may have a thickness in the range 30nm to 50nm. That is, the thickness of the third component 36 may be greater than or equal to 30nm and the thickness of the second component may be less than or equal to 50nm. It will be appreciated that, in other embodiments, the third component may have a different thickness.

The first component 32 and the second component 34 may be the same as in the attenuated phase shift patterning device MA of Figure 2, that is the first component 32 is a multilayer and the second component 34 may comprise Ru. In other embodiments, the second component 34 may comprise, for example, Rh, Tc, Mo or Re. The second component 34 may comprise an alloy of Ru, Rh, Tc, Mo or Re. These materials may have a refractive index with a relatively low real part n (e.g. less than 0.95) and a relatively low imaginary part k (e.g. less than 0.04). Thus, the second component 34 provides the phase shift and thereby enhances the contrast in the same way as described above. That is, the benefits of the attenuated phase shift patterning device MA of Figure 2 are also achieved using the attenuated phase shift patterning device 30.

In the same way as in Figure 2, the second component 34 covers a portion (i.e. a covered portion 32b) of the first component 32 except for an uncovered portion 32a of the surface of the first component 22 which forms a pattern. The third component 36 covers a second covered portion 32c of the first component 32, which is smaller than the covered portion 32b of the first component 32 that is covered by the second component 32.

The third component 36 covers the second covered portion 32c of the first component 32 being a distance of 20nm away from the uncovered portion 32a of the first component 32. In other embodiments, the second covered portion 32c may be greater than a distance of 20nm away from the uncovered portion 32a of the first component 32. For example, the second covered portion 32c may be in a range 20nm to 240nm away from the uncovered portion 32a of the first component 32. The distance being taken parallel to the surface of the first component 32. The range 20nm-240nm may be calculated based on a critical dimension (CD) of the feature to be printed on the substrate W of 10nm to 30nm. The distance the second covered portion 32c is away from the uncovered portion 32a of the first component 32 may be in a range 0.5*CD to 1*CD. A magnification factor from the substrate W to the patterning device 30 may be 4-8 and so this provides a range 20nm to 240nm. It will be appreciated that, in other embodiments, the distance may be changed accordingly based on the CD.

As can be seen in Figure 8b, the third component 36 covers the entire second component 34 except for an area surrounding the uncovered portion 32a of the first component 32 which extends a distance of 20nm away from the uncovered portion 32a. As detailed above, in other embodiments, this distance may be in the range 20nm-240nm.

The third component 36 is for absorbing radiation. The third component 36 comprises an alloy of Ta with a Ru capping layer. This Ru capping layer is in addition to the second component 34 which may also be Ru. The Ta alloy has a refractive index with a relatively high imaginary part (k). In other embodiments, the material may comprise Ta without another element present. In other embodiments, the third component may comprise a different material, such as Ag, Pt, Pd, Au, Ir, Os, Re, In, Co, Cd, Pb, Fe, Hg, TI, Cu, Zn, I, Te, Ga, Cr, W, Hf or an alloy comprising one or more of these materials, or a TaBN absorber. More generally, the third component 36 may comprise a material having a refractive index with a larger imaginary part (k) than the material of the second component 34, i.e. in this embodiment Ru. In some embodiments, the third component 36 may have a material having a refractive index with an imaginary part (k) in the range 0.031 (i.e. k of TaBN) to 0.08 (i.e. k of Ag). As an example, the imaginary part (k) may be 0.065 (i.e. k of Co).

The third component 36 is deposited on the second component 34 and absorbs radiation and suppresses the background intensity when the pattern contains isolated features (isolated uncovered portions 32a). Using the attenuated phase shift patterning device 30 may result in an aerial image such as shown in Figure 7c.

The attenuated phase shift patterning device 30 may be used in the lithographic apparatus LA by reflecting radiation from the first component 32 of the attenuated phase shift patterning device 30, reflecting radiation from the second component 34 of the attenuated phase shift patterning device 30, and absorbing radiation by the third component 36 of the attenuated phase shift patterning device 30. More particularly, reflecting radiation from the pattern comprising the uncovered portion 32a of the first component 32 and generating the patterned radiation beam B'. The effect of this is that the radiation reflected from the second component 34 has a different phase with respect to the radiation reflected from the first component 32 and provides a pattern on the substrate with increased contrast. The absorbing of the radiation by the third component 36 leads to at least a reduction of the background.

The part of the attenuated phase shift patterning device 30 which is not covered by the third component 36 may be considered to be an unpatterned part. Since the unpatterned part of attenuated phase shift patterning device 30 consists of highly absorbing material, i.e. the third component 36 comprising Ta, the background in the aerial image will be suppressed.

Thus, the attenuated phase shift patterning device 30 is suitable for isolated features in a pattern and provides strongly enhanced NILS through focus.

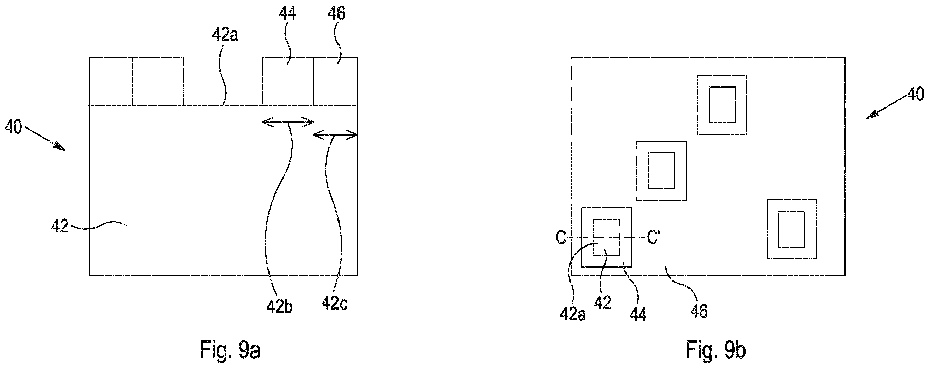

Figure 9a shows a side view of an embodiment of part of an attenuated phase shift patterning device 40. More particularly, Figure 9a shows a cross sectional side view of the attenuated phase shift patterning device 40 taken through line C-C' of Figure 9b. The attenuated phase shift patterning device 40 is shown more fully in Figure 9b in a top view.

The attenuated phase shift patterning device 40 is similar to the attenuated phase shift patterning device 30, except, the second component 44 is in the same layer as the third component 46. That is, the third component 46 does not cover the second component 44. This means that the attenuated phase shift patterning device 40 is thinner than the attenuated phase shift patterning device 30. The attenuated phase shift patterning device 30 may have advantages of ease of manufacture.

In the attenuated phase shift patterning device 40, the second component 44 covers a covered portion 42b of a first component 42 and the third component 46 covers a different, second covered portion 42c, which does not overlap with the covered portion 42b. This is different from the attenuated phase shift patterning device 30 where the covered portion 32b and second covered portion 32c overlap to some extent.

As can be seen in Figures 9a and 9b, the third component 46 covers the entire first component 42 except for the uncovered portion 42a of the first component 42 and the covered portion 42b of the first component 42 covered by the second component 44. The second component 44 may be considered to form a ring around the uncovered portion 42a of the first component 42. Similarly, the third component 46 may be considered to form a ring around the second component 44.

Again, the third component 46 is made from Ta or an alloy of Ta. In other embodiments, the third component may comprise a different material, such as Co or an alloy of Co, or TaBN.

The third component 46 absorbs radiation and suppresses the background intensity in the same way as the attenuated phase shift patterning device 30 of Figure 8. Using the attenuated phase shift patterning device 40 may result in an aerial image such as shown in Figure 7c. Thus, the attenuated phase shift patterning device 40 is suitable for isolated features (i.e. isolated uncovered portions 42a) in a pattern and provides strongly enhanced NILS through focus.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An attenuated phase shift patterning device comprising:
a first component for reflecting radiation, and
a second component for reflecting radiation with a different phase with respect to the radiation reflected from the first component, the second component covering at least a portion of the surface of the first component such that a pattern comprising at least one uncovered portion of the first component is formed for generating a patterned radiation beam in a lithographic apparatus in use,
wherein the second component comprises a material having a refractive index with a real part (n) being less than 0.95 and an imaginary part (k) being less than 0.04.

2. The attenuated phase shift patterning device of claim 1, wherein the second component comprises at least one of Ru, Rh, Tc, Mo and Re.

3. The attenuated phase shift patterning device of claim 2, wherein the second component comprises an alloy comprising at least one of Ru, Rh, Tc, Mo and Re.

4. The attenuated phase shift patterning device of any preceding claim, wherein the second component has a thickness in the range 30 to 45nm.

5. The attenuated phase shift patterning device of claim 4, wherein the second component has a thickness of 35 or 41nm.

6. The attenuated phase shift patterning device of any preceding claim, wherein the second component covers the portion of the first component which extends a distance of at least 10nm from the at least one uncovered portion of the first component.

7. The attenuated phase shift patterning device of any preceding claim, further comprising a third component for absorbing radiation, the third component comprising a material having a refractive index with a larger imaginary part (k) than the material of the second component, the third component covering at least a portion of the first component.

8. The attenuated phase shift patterning device of claim 7, wherein the material of the third component has a refractive index with an imaginary part (k) in the range 0.031 to 0.08.

9. The attenuated phase shift patterning device of either of claims 7 or 8, wherein the third component covers the portion of the first component which is greater than or equal to a distance in the range 20 to 240nm from the at least one uncovered portion of the first component.

10. The attenuated phase shift patterning device of any of claims 7-9, wherein the third component does not cover the second component.

11. The attenuated phase shift patterning device of any of claims 7-9, wherein the third component covers at least a portion of the second component.

12. The attenuated phase shift patterning device of any of claims 7-11, wherein the third component comprises at least one of Ta, Ag, Pt, Pd, Au, Ir, Os, Re, In, Co, Cd, Pb, Fe, Hg, TI, Cu, Zn, I, Te, Ga, Cr, W, Hf, TaBN, and an alloy comprising one or more of Ta, Ag, Pt, Pd, Au, Ir, Os, Re, In, Co, Cd, Pb, Fe, Hg, TI, Cu, Zn, I, Te, Ga, Cr, W, and Hf.

13. The attenuated phase shift patterning device of any of claims 1-9 and 11-12, wherein the second component covers the entire first component except the at least one uncovered portion of the first component.

14. The attenuated phase shift patterning device of any preceding claim, wherein the first component is a multilayer.

15. A method of using an attenuated phase shift patterning device, comprising:
reflecting radiation from a first component of the attenuated phase shift patterning device, and
reflecting radiation from a second component of the attenuated phase shift patterning device such that the radiation reflected from the second component has a different phase with respect to the radiation reflected from the first component, the second component covering at least a portion of the surface of the first component such that a pattern comprising at least one uncovered portion of the first component is formed for generating a patterned radiation beam,
wherein the second component comprises a material having a refractive index with a real part (n) being less than 0.95 and an imaginary part (k) being less than 0.04.

16. The method of claim 15, further comprising absorbing radiation using a third component having a refractive index with a larger imaginary part (k) than the second component, the third component covering at least a portion of the first component.
